# EUROPEAN PATENT APPLICATION

(11) **EP 2 849 339 A1**
(43) Date of publication of application: **18.03.2015**
(21) Application number: 13290220.6
(22) Date of filing: 13.09.2013
(51) Int. Cl.: H03F 3/217, H03M 3/00

(54) **Correction of an output signal**

(71) Applicant: ALCATEL LUCENT, 92100 Boulogne-Billancourt (FR)
(72) Inventor: Dartois, Luc, 91620 Nozay (FR)
(74) Representative: Greenwood, Matthew David

(57) **Abstract**

A method for feed-forward correction of an output signal for a digital radio-frequency front end, comprising receiving a complex digital input signal including an in-phase component and a quadrature-phase component, modulating the complex signal using a sigma-delta modulator to provide respective intermediate signal components, providing a weighted sum signal representing an aggregated digital sum of the intermediate signal components, comparing the digital weighted sum signal with the digital input signal to determine a composite detected error representing quantisation and/or phase-amplitude modulation noise and distortion, and correcting the output signal by subtracting the composite detected error therefrom.

## Description

### TECHNICAL HELD

The present invention relates generally to switched mode power amplifiers and more particularly, although not exclusively to feed-forward correction of an output signal for a digital radio-frequency front end.

### BACKGROUND

In Radio Frequency (RF) communications, switched-mode technology can be used to achieve high power efficiency in RF power amplifiers. Switched-mode means that the power transistors are either in a fully conducting state or in a completely shut-off state. A filter at the output is then often needed to remove unwanted harmonics and quantization noise of the switch frequency.

For a switched-mode power amplifier (SMPA) in a full digital implementation, the signal quality and useful band centred around a carrier frequency can be limited by two native defects: the noise shape of a delta sigma modulator (DSM) and its band pass limited noise transfer function (NTF), which can create fast growing noise, and so-called "Vandana" or phase to amplitude (PMAM) distortion that can cause images, intermodulation products and harmonics for each frequency bin of the signal and whose level grows when the signal is further from centre frequency. This effect also limits the clean useable bandwidth as well as creating some residual error vector magnitude in the proper signal generation itself.

Typically, DSM noise appearing outside a signal band is suppressed using a power amplifier reconstruction filter or by an internal filter using transistor delayed fingers. With constellation based DSM encoders, depending on the constellations, some PMAM effects can also create in band inter modulation regrowth in the digital domain that no known method can pre- or post- compensate for.

### SUMMARY

According to an example, there is provided a method for feed-forward correction of an output signal for a digital radio-frequency front end, comprising receiving a complex digital input signal including an in-phase component and a quadrature-phase component, modulating the complex signal using a sigma-delta modulator to provide respective intermediate signal components, providing a weighted sum signal representing an aggregated digital sum of the intermediate signal components, comparing the digital weighted sum signal with the digital input signal to determine a composite detected error representing quantisation and/or phase-amplitude modulation noise and distortion and correcting the output signal by subtracting the composite detected error therefrom. The weighted signal can be aligned in time, phase and gain with the input signal. The input signal for comparison can be generated using a noise free sigma-delta modulator which takes the complex input signal as input. The noise free modulator can be a quasi-ideal clone of a primary modulator used to modulate the input signal. That is, the clone can be arranged to provide a modulated signal that is free from, or substantially free from defects which would otherwise be introduced as a result of the modulation.

The input signal for comparison can be a baseband sigma-delta modulated signal. The error signal can be transformed into a digital pulse train signal by means of a sigma delta modulator.

According to an example, there is provided a signal modulation device for providing an output signal for a radio frequency front end, comprising an input to receive a complex multi-component digital input signal, an analogue-to-digital converter to modulate respective ones of the components of the complex signal to provide intermediate signal components, a summation unit to provide a weighted sum signal representing an aggregated digital sum of the intermediate signal components, a comparator to compare the digital weighted sum signal with the digital input signal to determine a composite detected error including components representing quantisation and/or phase-amplitude modulation noise and distortion, and means to adjust the output signal using the composite detected error to provide an adjusted output signal. The device can further include means to align the weighted signal in time, phase and gain with the input signal. The device can further include a noise free modulator device to take the complex input signal as input and to generate the input signal for comparison. The device can be arranged to receive a baseband sigma-delta modulated signal as input for comparison. The device can further include a sigma delta modulator to transform the error signal into a digital pulse train signal.

According to an example, there is provided a transmit chain for a digital radio-frequency front end, comprising an input to receive a complex digital input signal including an in-phase component and a quadrature-phase component, a sigma-delta modulator to modulate the complex signal to provide respective intermediate signal components, means to provide a weighted sum signal representing an aggregated digital sum of the intermediate signal components, a comparator to compare the digital weighted sum signal with the digital input signal to determine a composite detected error representing quantisation and/or phase-amplitude modulation noise and distortion, and a subtracting means to correct the output signal by subtracting the composite detected error therefrom. The transmit chain can further include means to align the weighted signal in time, phase and gain with the input signal. The transmit chain can further include a noise free modulator device to take the complex input signal as input and to generate the input signal for comparison. The transmit chain can be arranged to receive a baseband sigma-delta modulated signal as input for comparison. The transmit chain can further include a sigma delta modulator to transform the error signal into a digital pulse train signal.

### BRIEF DESCRIPTION OF THE DRAWINGS

Embodiments will now be described, by way of example only, with reference to the accompanying drawings, in which:
Figure 1 is a schematic representation of a power amplifier chain;
Figure 2 is a schematic representation of a power amplifier chain including a converter;
Figure 3 is a schematic representation of a portion of a transmit chain architecture according to an example;
Figure 4 is a schematic representation of a portion of a transmit chain architecture according to an example; and
Figure 5 is a schematic representation of a portion of a transmit chain architecture according to an example.

### DETAILED DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

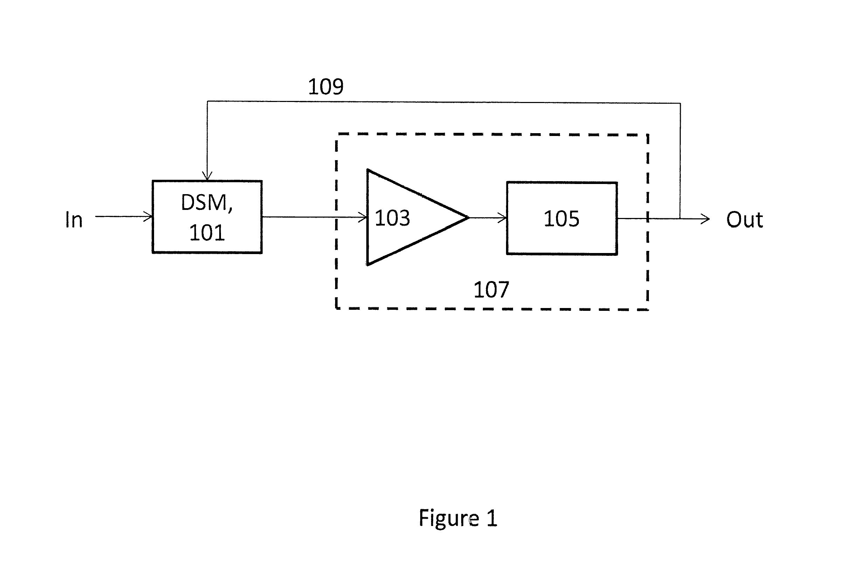

Power amplifiers used in communication systems can be identified by classes which are defined according to their operation features. For instance, power amplifiers might be classified as D class - when they mainly operate on the basis of a single transistor state - or S class - when they mainly operate on the basis of two transistors states. In this latter case, the S class amplifier can be further classified into 1 bit or 1.5 bits depending on whether two states (only one of the two transistors drives a current in each state) or three states (two states previously indicated added to a third state whereby none of the transistors drives a current). In order to feed such S or D class power amplifier with a pulsed bit stream signal, it is known to use an amplifying chain which converts a radio frequency (RF) signal IN (figure 1) into an RF pulsed signal OUT using a delta-sigma modulator 101 which outputs a pulsed bit stream signal, eventually through a Pulse Width Modulator (PWM) and/or a pulse position modulator (PPM) (not shown) when the sigma delta modulator 101 provides a multibit pulsed signal. Thereafter the power amplifier 103, operating in a switching mode, amplifies the RF pulsed signal received from the delta-sigma modulator 101 to a required level set in the system, and outputs the amplified RF pulse signal to the band-pass filter 105. In the example of figure 1, the delta-sigma modulator 101 converts a modulated input signal into a high speed pulse train which generates, by nature, quantization noises at an outer band of the signal.

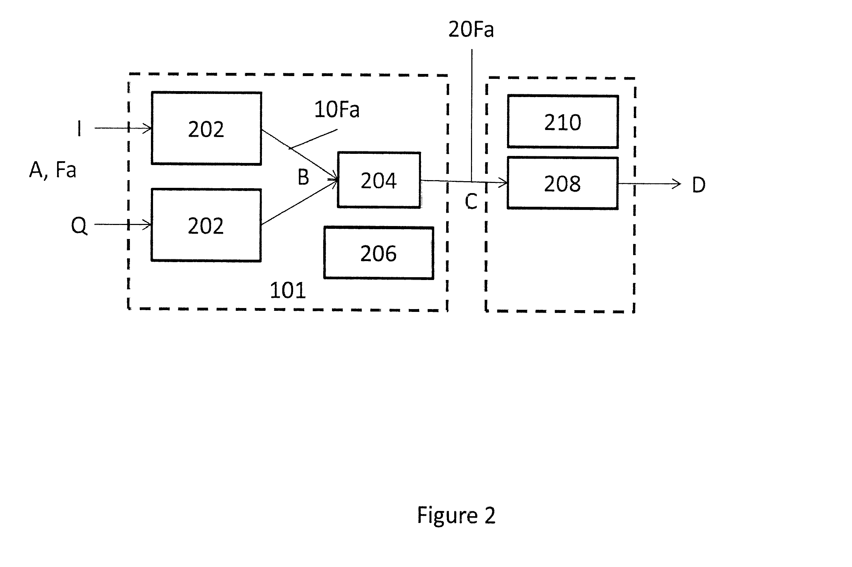

The structure of the delta-sigma modulator 101 is represented in more detail in figure 2 as an association of sigma-delta modulation (SDM) means 202, for instance comprising forward integrators and a converter 204, associated to a sample RAM (random access memory) 206, which also performs signal oversampling in order to output an oversampled signal to the pulse-width-modulator (PWM) 208 associated to a clock 210. In operation, a baseband input signal A, can be received as two parallel scalar components, i.e. an in-phase component denoted by I and a quadrature-phase component denoted by Q. In the following, there will be described signal processing methods applied to the complex baseband signal, e.g. sigma delta modulation. By virtue of linearity, the skilled person will appreciate that the sigma delta modulation of complex signals can be implemented as two parallel sigma delta modulation processes for each scalar component making up the complex signal. The signal A is treated by the SDM means 101 to be modulated into an intermediate signal B which, in this example, is oversampled by the converter/oversampler 204 by two so that the frequency of the oversampled and RF transposed signal B (called signal C) is 20Fa. Considering, for instance, that signal A has a sampling rate Fa of 414.72MHz, it might be sampled by the delta-sigma modulation means 202 by a factor 10 so that the sampled signal B has a sampling rate of 4.1472 GHz while the oversampling of the signal C is operated on a sampling rate of 8.2944 GHz and is transposed to a carrier centre frequency of 2.0736GHz.

In an example, an evolved digital transmission chain used in wireless communications networks, for instance in 3G, 4G and above, can use a switched-mode power amplifier. The radio carrier frequencies used in such networks depend on both technical and regional spectrum regulatory constraints and range typically between 700 MHz and 2.7 GHz.

The modulation device 101 transmits to the radio front-end 107 a frequency-converted time-domain pulsed signal that encodes the information content of the baseband signal in the position and/or width and/or amplitude of the pulses. A band pass sigma delta modulator operates to frequency-convert a useful information signal into a frequency band of interest, also known as a clean bandwidth, while rejecting quantification noise outside the frequency band of interest. The noise transfer function of such a modulator has a typical notched envelope. The quantification noise rejected outside the clean bandwidth can be post-filtered by the band pass output filter 105. The band pass sigma delta modulator can be designed so that its clean bandwidth is centred on a selected carrier frequency (Fc) of the RF transmitter.

According to an example, feed-forward correction of an output signal for a digital radio-frequency front end uses an image of a sum of errors from in-phase and quadrature signals to complement signal generation so that the native DSM signal minus this error, when combined together at a SMPA output nulls or significantly reduces those errors. That is, a complex digital input signal including an in-phase component and a quadrature-phase component is modulated using, for example, a sigma-delta modulator to provide respective intermediate signal components. A weighted sum signal representing an aggregated digital sum of the intermediate signal components is generated which is compared with the digital input signal to determine a composite detected error representing quantisation and/or phase-amplitude modulation noise and distortion. An output signal can thus be corrected by subtracting the composite detected error.

According to an example, a composite detected error can be calculated in several different ways, all based on an aligned and balanced comparison between a DSM and constellation based generated signal and a representation of an ideal or quasi-ideal input reference signal.

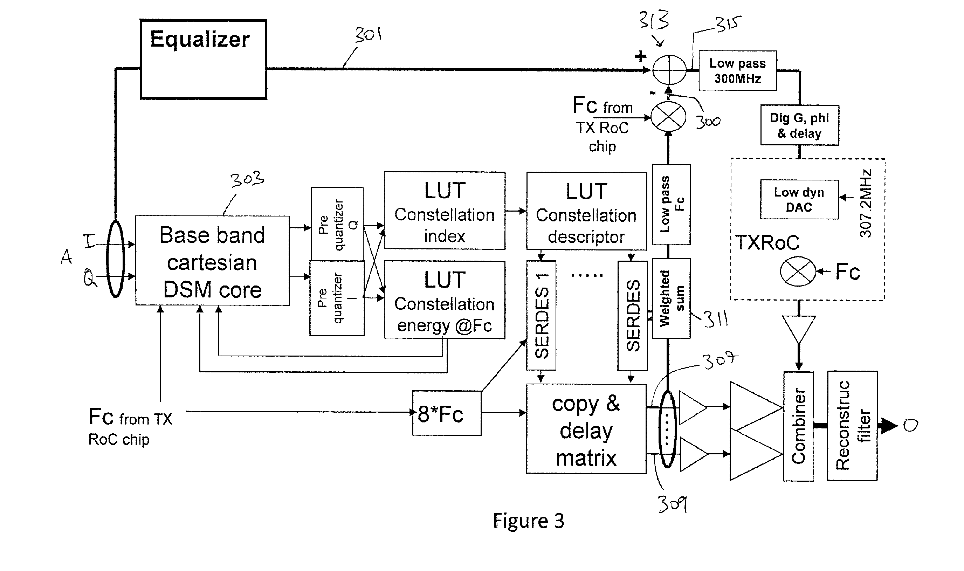

Figure 3 is a schematic representation of a portion of a transmit chain architecture according to an example.

A synthesized digital signal 300 transposed back to baseband is compared to a baseband undersampled representation of a transmission signal 301. Signal 301 can be the I and Q digital input signal for the SMPA encoder. This reference signal is both NTF free and Vandana distortion free.

Accordingly, I and Q components of an input signal A are equalised to provide signal 301. Signal A is processed in a known way to modulate the input signal using DSM 303 to provide respective intermediate signal components 307, 309. A weighted sum signal 311 representing an aggregated digital sum of the intermediate signal components is generated which is compared with the digital input signal using a comparator 313 to determine a composite detected error 315 representing quantisation and/or phase-amplitude modulation noise and distortion. An output signal O can thus be corrected by subtracting the composite detected error.

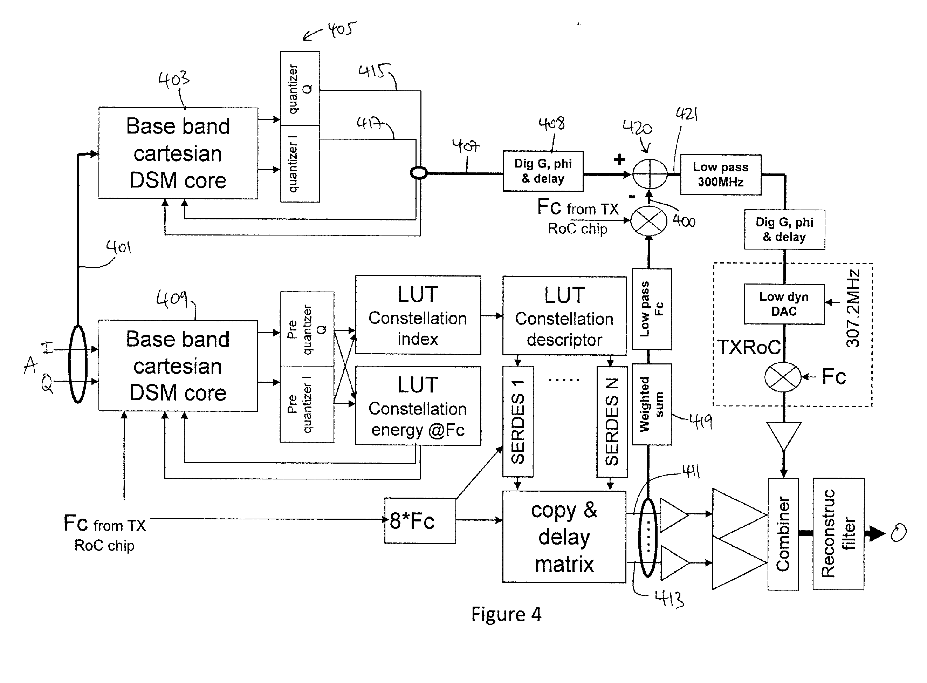

Figure 4 is a schematic representation of a portion of a transmit chain architecture according to an example. A synthesized digital signal 400 transposed back to baseband is compared to a baseband oversampled representation of an input signal copy 401 passed to a quasi-ideal clone of a primary DSM encoder 403 that has a quasi-perfect multibit quantizer 405. The reference signal obtained, 407, is both NTF free and Vandana distortion free. The reference signal 407 can be aligned in phase, gain and time with input A using means 408, which can include a delay unit, an amplifier, and phase correcting unit for example, all of which are typical for adjusting such parameters of a signal as desired.

Accordingly, I and Q components of an input signal A are modulated using a DSM 409 to provide respective intermediate signal components 411, 413. The I and Q components of the input signal A are also modulated using the quasi-ideal clone 403 of the DSM 409. After quantisation using quasi-perfect multibit quantizer 405, respective intermediate signal components 415, 417 are generated.

A weighted sum signal 419 representing an aggregated digital sum of the intermediate signal components 411, 413 is generated which is compared with the digital signal 407 using a comparator 420 to determine a composite detected error 421 representing quantisation and/or phase-amplitude modulation noise and distortion. Output signal O can thus be corrected by subtracting the composite detected error.

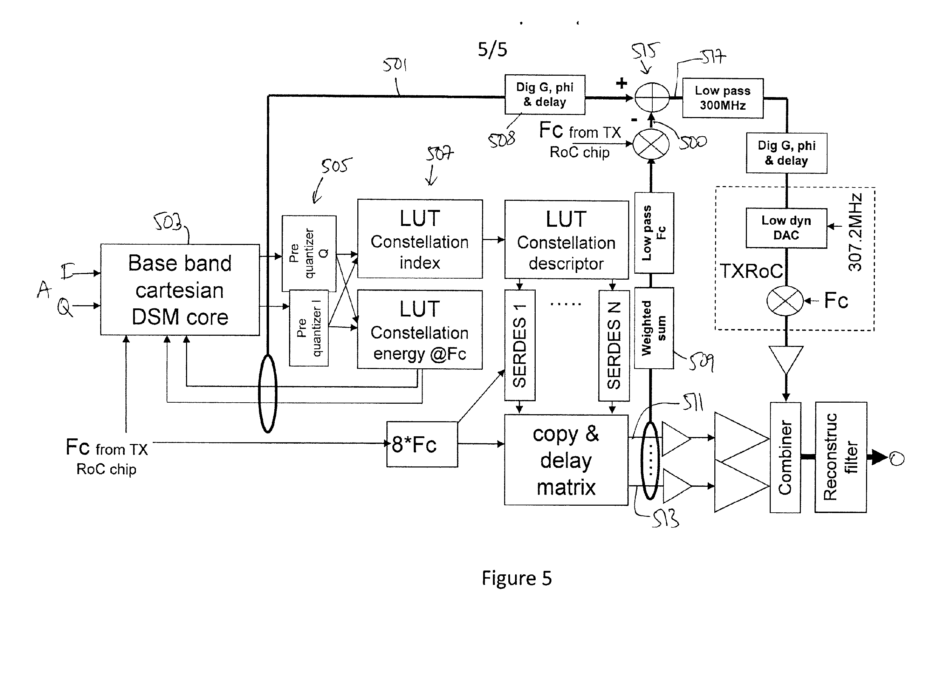

Figure 5 is a schematic representation of a portion of a transmit chain architecture according to an example. A synthesized digital signal 500 transposed back to baseband is compared to a primary DSM constellation energy feedback signal 501 which is still affected by DSM noise but not by any Vandana effect.

Accordingly, I and Q components of an input signal A are processed using DSM 503, pre-quantizer 505 and using the constellation indexes 507 and provide the primary DSM constellation energy feedback signal 501. The signal 501 can be aligned in phase, gain and time with input A using means 508, which can include a delay unit, an amplifier, and phase correcting unit for example, all of which are typical for adjusting such parameters of a signal as desired.

A weighted sum signal 509 representing an aggregated digital sum of the intermediate signal components 511, 513 is generated which is compared with the signal 501 using a comparator 515 to determine a composite detected error 517 representing quantisation and/or phase-amplitude modulation noise and distortion. An output signal O can thus be corrected by subtracting the composite detected error. The corrected output is substantially free from Vandana effects, but is still a representation of the native DSM output 501, and will therefore still typically include residual in band quantization noise. However, it has the advantage of minimizing the implementation complexity as the reference signal 501 is natively present in the signal generation chain as the native DSM feedback signal.

For each method, the processing speed in the data paths is improved by pre-storage of filtered signal wavelets at the expense of a signal memory size expansion. Also, the error used for correction is generated in the form a fully integrated full digital bit stream, which is compatible with native DSM based technology for integrated encoders.

Accordingly, examples provide for the digital correction of intrinsic DSM and PPWM signal generation defects by the prediction/calculation of a sum of encoder digital errors. A composite error signal determined from an aggregated digital sum of intermediate signal branches can be compared with a reference clean digital signal representation, or a processed reference signal in order to correct output signal defects. The generation/subtraction of corresponding errors can be performed on a controlled and limited band

With some types of SMPA transistors and some lower power classes the examples described herein can provide an SMPA transmit chain without the need for an end to end DPD loop. The methods described herein can reduce noise and digital distortions sources by 30 to 40dB in a more than 200-300MHz band for a 2GHz carrier, and provide a fully digital integrated solution including error correction with no D/A converter and a fully synchronous data path.

The present inventions can be embodied in other specific apparatus and/or methods. The described embodiments are to be considered in all respects as illustrative and not restrictive. In particular, the scope of the invention is indicated by the appended claims rather than by the description and figures herein. All changes that come within the meaning and range of equivalency of the claims are to be embraced within their scope.

## Claims

1. A method for feed-forward correction of an output signal for a digital radio-frequency front end, comprising:
receiving a complex digital input signal including an in-phase component and a quadrature-phase component;
modulating the complex signal using a sigma-delta modulator to provide respective intermediate signal components;
providing a weighted sum signal representing an aggregated digital sum of the intermediate signal components;
comparing the digital weighted sum signal with the digital input signal to determine a composite detected error representing quantisation and/or phase-amplitude modulation noise and distortion; and
correcting the output signal by subtracting the composite detected error therefrom.

2. A method as claimed in claim 1, further including aligning the weighted signal in time, phase and gain with the input signal.

3. A method as claimed in claim 1 or 2, wherein the input signal for comparison is generated using a noise free sigma-delta modulator which takes the complex input signal as input.

4. A method as claimed in claim 1 or 2, wherein the input signal for comparison is a baseband sigma-delta modulated signal.

5. A method as claimed in claim 1 or 2, wherein the error signal is transformed into a digital pulse train signal by means of a sigma delta modulator.

6. A signal modulation device for providing an output signal for a radio frequency front end, comprising:
an input to receive a complex multi-component digital input signal;
an analogue-to-digital converter to modulate respective ones of the components of the complex signal to provide intermediate signal components;
a summation unit to provide a weighted sum signal representing an aggregated digital sum of the intermediate signal components;
a comparator to compare the digital weighted sum signal with the digital input signal to determine a composite detected error including components representing quantisation and/or phase-amplitude modulation noise and distortion; and
means to adjust the output signal using the composite detected error to provide an adjusted output signal.

7. A device as claimed in claim 6, further including means to align the weighted signal in time, phase and gain with the input signal.

8. A device as claimed in claim 6 or 7, further including a noise free modulator device to take the complex input signal as input and to generate the input signal for comparison.

9. A device as claimed in claim 6 or 7, arranged to receive a baseband sigma-delta modulated signal as input for comparison.

10. A device as claimed in claim 6 or 7, further including a sigma delta modulator to transform the error signal into a digital pulse train signal.

11. A transmit chain for a digital radio-frequency front end, comprising:
an input to receive a complex digital input signal including an in-phase component and a quadrature-phase component;
a sigma-delta modulator to modulate the complex signal to provide respective intermediate signal components;
means to provide a weighted sum signal representing an aggregated digital sum of the intermediate signal components;
a comparator to compare the digital weighted sum signal with the digital input signal to determine a composite detected error representing quantisation and/or phase-amplitude modulation noise and distortion; and
a subtracting means to correct the output signal by subtracting the composite detected error therefrom.

12. A transmit chain as claimed in claim 11, further including means to align the weighted signal in time, phase and gain with the input signal.

13. A transmit chain as claimed in claim 11 or 12, further including a noise free modulator device to take the complex input signal as input and to generate the input signal for comparison.

14. A transmit chain as claimed in claim 11 or 12, arranged to receive a baseband sigma-delta modulated signal as input for comparison.

15. A transmit chain as claimed in claim 11 or 12, further including a sigma delta modulator to transform the error signal into a digital pulse train signal.
